# FASCICULE DE BREVET EUROPEEN

(11) **EP 3 141 520 B1**
(45) Date de publication et mention de la délivrance du brevet: **14.03.2018**
(21) Numéro de dépôt: 15184189.7
(22) Date de dépôt: 08.09.2015
(51) Int. Cl.: B81B 3/00, G04B 15/14, G04B 19/12, G04B 31/08

(54) **PROCÉDÉ DE FABRICATION D'UNE PIÈCE MICROMÉCANIQUE HORLOGÈRE ET LADITE PIÈCE MICROMÉCANIQUE HORLOGÈRE**
HERSTELLUNGSVERFAHREN FÜR EIN MIKROMECHANISCHES UHRENBAUTEIL UND ENTSPRECHENDES MIKROMECHANISCHES UHRENBAUTEIL
METHOD FOR MANUFACTURING A MICROMECHANICAL TIMEPIECE PART AND SAID MICROMECHANICAL TIMEPIECE PART

(43) Date de publication de la demande: 15.03.2017
(73) Titulaire: Nivarox-FAR S.A., 2400 Le Locle (CH)
(72) Inventeur: Dubois, Philippe, 2074 Marin (CH)
(74) Mandataire: Honoré, Anne-Claire

(56) Documents cités:
- EP-A1- 1 705 533
- EP-A1- 2 865 737
- CH-A1- 708 998
- DE-A1-102009 046 647
- DE-B3-102013 113 380
- H. FÖLL ET AL: "Formation and application of porous silicon", MATERIALS SCIENCE AND ENGINEERING R: REPORTS, vol. 39, no. 4, 1 novembre 2002 (2002-11-01), pages 93-141, XP055254970, CH ISSN: 0927-796X, DOI: 10.1016/S0927-796X(02)00090-6
- LANG W: "Silicon microstructuring technology", MATERIALS SCIENCE AND ENGINEERING R: REPORTS, ELSEVIER SEQUOIA S.A., LAUSANNE, CH, vol. 17, no. 1, 1 septembre 1996 (1996-09-01), pages 1-55, XP004013096, ISSN: 0927-796X, DOI: 10.1016/0927-796X(96)00190-8
- GENTILE F ET AL: "Fractal structure can explain the increased hydrophobicity of nanoporous silicon films", MICROELECTRONIC ENGINEERING, ELSEVIER PUBLISHERS BV., AMSTERDAM, NL, vol. 88, no. 8, 17 janvier 2011 (2011-01-17), pages 2537-2540, XP028098160, ISSN: 0167-9317, DOI: 10.1016/J.MEE.2011.01.046 [extrait le 2011-01-28]

## Description

### Domaine de l'invention

La présente invention se rapporte à un procédé pour produire des pièces micromécaniques horlogères à base de silicium. L'invention se rapporte également à une pièce micromécanique horlogère renforcée, à base de silicium, pouvant notamment être obtenue par un tel procédé.

### Arrière-plan de l'invention

Le silicium est un matériau de plus en plus utilisé dans la fabrication de pièces micromécaniques horlogères, notamment des pièces qui restent liées à un substrat à base de silicium sur lequel elles ont été usinées.

Par rapport aux métaux ou alliages classiquement utilisés pour fabriquer des pièces micromécaniques horlogères, telles que des roues dentées, ou les composants de l'échappement, le silicium présente de nombreux avantages. C'est un matériau très dur, d'un poids très léger qui lui permet donc de présenter une inertie très réduite et en conséquence d'améliorer le rendement. Le silicium permet également de réaliser des pièces complexes, ou monobloc.

Afin d'améliorer ou modifier les propriétés du silicium, il est connu de déposer sur le silicium une couche d'un matériau approprié. Ainsi, pour améliorer ses propriétés tribologiques, on dépose sur le silicium du diamant, par exemple par un procédé de dépôts de couche mince en phase vapeur (CVD/PVD).

Toutefois, ces procédés présentent un taux de dépôt qui peut s'avérer trop lent lorsque l'épaisseur de la couche déposée dépasse quelques microns. En effet, les taux de dépôts dans les machines CVD par exemple étant typiquement de l'ordre de la dizaine de nanomètre/minute, cette technique n'est généralement pas utilisée pour la fabrication de couche supérieure à quelques microns.

Il est donc nécessaire de proposer un procédé de fabrication d'une pièce micromécanique horlogère à base de silicium permettant de réaliser des dépôts rapides de couches épaisses d'un matériau approprié sur le silicium.

Par ailleurs, des substrats à base de silicium peuvent être utilisés pour réaliser des cadrans.

Les cadrans des montres ou autre pièce d'horlogerie comportent des inscriptions ou des surfaces décoratives permettant de donner des indications ou de mettre en valeur le cadran. Ces décorations sont traditionnellement réalisées par différentes techniques de gravure.

Lorsque le cadran est réalisé à base de silicium, il est nécessaire de proposer de nouvelles techniques pour réaliser de telles inscriptions ou de surfaces décoratives, faciles à mettre en oeuvre.

Par ailleurs, tout comme les autres matériaux utilisés plus classiquement dans l'horlogerie, les pièces réalisées à partir d'un substrat à base de silicium doivent être lubrifiées.

Il est connu d'utiliser par exemple un agent lubrifiant très fluide qui favorise un faible coefficient de frottement dans le cas de faibles pressions de contact. Toutefois, ce type de lubrifiant présente l'inconvénient de voir son effet s'estomper notamment lors de pressions de contact plus élevées du fait de la rupture du film lubrifiant. Il est connu que les techniques de supra-lubrification, basées sur la formation de brosses polymères (polymer brushes) déposées en surface et leur imprégnation avec un lubrifiant ayant une affinité avec les brosses polymères, permettent de réduire grandement le frottement pour une large gamme de sollicitations. Ces brosses polymères très souples se redressent lorsqu'elles sont imprégnées par le lubrifiant formant ainsi une sorte d'éponge gorgée de lubrifiant. Selon les régimes de frottement, lors de pressions de contact importantes, les filaments peuvent aisément se comprimer et restituer du lubrifiant dans le contact. Cela a pour conséquence la formation d'un film lubrifiant plus important qui aboutit à une baisse substantielle du coefficient de frottement et de l'usure. Toutefois, lors de sollicitations de longue durée, ces brosses polymères finissent par se dégrader (usure, arrachement de la surface), ce qui ne permet plus au revêtement de brosses polymères d'assurer sa fonction.

Il est donc nécessaire de proposer une nouvelle méthode pour lubrifier une pièce micromécanique horlogère à base de silicium permettant de contenir à la surface de la pièce à lubrifier des quantités suffisantes d'agent lubrifiant afin de réduire la fréquence des services d'entretien du mouvement horloger comprenant ladite pièce.

Il est également nécessaire de proposer une nouvelle méthode pour lubrifier une pièce micromécanique horlogère à base de silicium permettant de créer des conditions de lubrification permettant une réduction significative de l'usure et du coefficient de frottement, de manière à accroitre la fiabilité, le rendement et par conséquent la réserve de marche du mouvement horloger comportant cette pièce, et cela pour une large gamme de sollicitations.

### Résumé de l'invention

A cet effet, la présente invention concerne un procédé de fabrication d'une pièce micromécanique horlogère à partir d'un substrat à base de silicium, comprenant, dans l'ordre, les étapes de :
a) se munir d'un substrat à base de silicium
b) former des pores à la surface d'au moins une partie d'une surface dudit substrat à base de silicium d'une profondeur d'au moins 10 µm, de préférence d'au moins 50 µm, et plus préférentiellement d'au moins 100 µm, lesdits pores étant agencés pour déboucher à la surface externe de la pièce micromécanique horlogère
dans lequel les pores sont formés sur le substrat à base de silicium pour constituer au moins une zone superhydrophobe à effet épilame par rapport à au moins une zone du substrat à base de silicium ne comprenant pas de pore et sur laquelle est appliqué un agent tribologique.

Le procédé selon l'invention permet, grâce à la formation préalable de pores à la surface du substrat, d'améliorer différentes propriétés d'un substrat à base de silicium utilisé dans les pièces micromécaniques horlogères.

La présente invention concerne également une pièce micromécanique horlogère comprenant un substrat à base de silicium qui présente, à la surface d'au moins une partie d'une surface dudit substrat à base de silicium, des pores d'une profondeur d'au moins 10 µm, de préférence d'au moins 50 µm, et plus préférentiellement d'au moins 100 µm, lesdits pores étant agencés pour déboucher à la surface externe de la pièce micromécanique horlogère, les pores étant agencés sur le substrat à base de silicium pour constituer au moins une zone superhydrophobe à effet épilame par rapport à au moins une zone du substrat à base de silicium ne comprenant pas de pore et sur laquelle est appliqué un agent tribologique.

### Brève description des dessins

Les buts, avantages et caractéristiques de la présente invention apparaîtront plus clairement dans la description détaillée suivante de différentes formes de réalisation de l'invention données uniquement à titre d'exemples non limitatifs et illustrées par les dessins annexés sur lesquels :
- les figures 1 à 3 illustrent schématiquement les étapes d'un procédé de fabrication n'appartenant pas à l'invention,
- les figures 4 à 6 illustrent schématiquement les étapes d'une autre variante d'un procédé de fabrication n'appartenant pas à l'invention, et
- les figures 7 à 9 illustrent schématiquement les étapes d'une autre variante d'un procédé de fabrication n'appartenant pas à l'invention.

### Description détaillée de l'invention

Le procédé de fabrication d'une pièce micromécanique horlogère à partir d'un substrat à base de silicium selon l'invention comprend dans l'ordre, les étapes de :
a) se munir d'un substrat à base de silicium
b) former des pores à partir de la surface d'au moins une partie d'une surface dudit substrat à base de silicium d'une profondeur d'au moins 10 µm, de préférence d'au moins 50 µm, et plus préférentiellement d'au moins 100 µm, lesdits pores étant agencés pour déboucher à la surface externe de la pièce micromécanique horlogère.

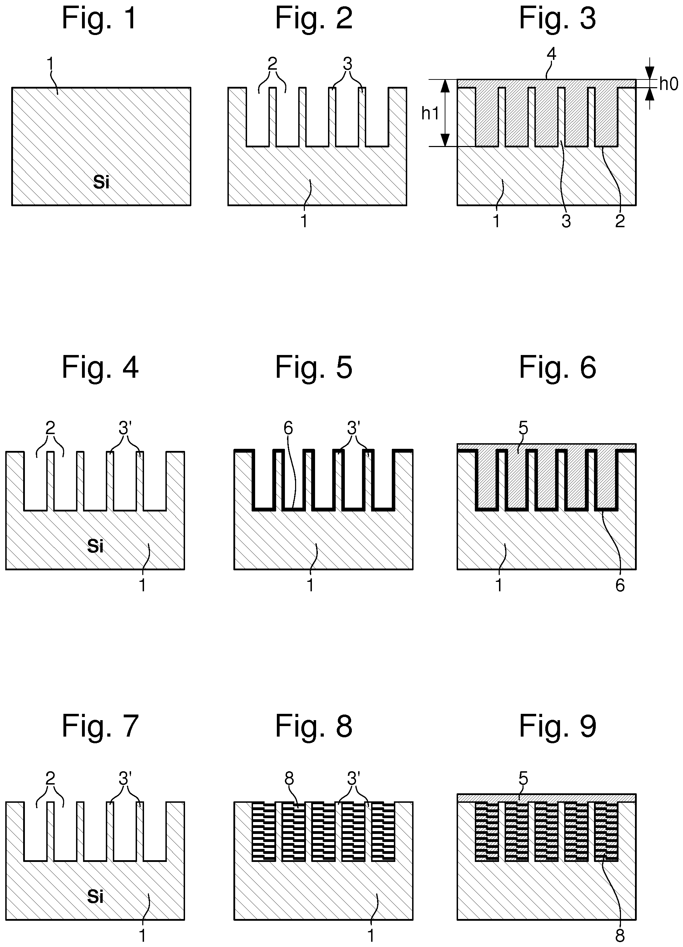

Le substrat à base de silicium est choisi en fonction de la pièce micromécanique horlogère à former. La forme finale du substrat à base de silicium en fonction de la pièce micromécanique horlogère à fabriquer est donnée avant ou après la mise en oeuvre du procédé de l'invention. Dans la présente invention, l'expression « substrat à base de silicium » désigne aussi bien une couche de silicium dans un substrat qu'un substrat en silicium. De préférence, comme représenté sur la figure 1, le substrat à base de silicium 1 est issu d'un wafer de silicium ou d'un wafer SOI (Silicon-on-Insulator). Les pores peuvent être formés aussi bien à la surface parallèle au plan du substrat qu'à la surface perpendiculaire au plan du substrat.

D'une manière avantageuse, cette étape b) peut être réalisée par un procédé choisi parmi le groupe comprenant un procédé par attaque électrochimique, un procédé de type « Stain-etch », et un procédé de type « MAC-Etch ».

Le procédé par attaque électrochimique peut être un procédé par anodisation électrochimique. Sa mise en oeuvre nécessite l'utilisation d'un bain électrochimique contenant de l'acide fluorhydrique en solution aqueuse ou mélangé à de l'éthanol dans des concentrations de 1 à 10%. Un courant électrique et des électrodes sont nécessaires pour créer des conditions électrochimiques induisant l'attaque du silicium. Selon les conditions électrochimiques, différents types de pores peuvent être obtenus. Un tel procédé est connu de l'homme du métier et ne nécessite pas d'informations détaillées ici.

Le procédé de type « Stain-etch » est basé sur une attaque humide du silicium aboutissant directement à la formation de silicium poreux. Typiquement, l'attaque se fait avec une solution HF/HNO₃/H₂O avec un rapport HF:HNO₃ de 50-500:1. Ce procédé présente l'avantage de ne pas nécessiter d'apport électrique dans le bain. Un tel procédé est connu de l'homme du métier et ne nécessite pas d'informations détaillées ici.

De préférence, l'étape b) est réalisée par un procédé de type « MAC-Etch ». Ce procédé est basé sur l'utilisation de particules de métaux nobles pour catalyser des réactions d'attaques chimiques locales. Typiquement, une couche très mince (10-50 nm) d'un métal noble (or, argent, platine) est déposée et structurée de manière aléatoire ou par lift-off, attaque, laser, etc. De préférence, le métal noble est de l'or. Plus particulièrement, on peut utiliser avantageusement des particules d'or en solution dans un mélange HF/H₂O₂ La taille des particules peut être comprise entre 5 et 1000 nm. La structuration peut être obtenue par lithographie de l'or, attaque ou lift-off. Une autre option est l'évaporation ou la pulvérisation cathodique (sputtering) d'une couche très fine non fermée (5-30 nm). Un traitement thermique pourra contribuer à la formation d'ilots d'or.

Lorsque le silicium avec la couche de métal noble est plongé dans une solution aqueuse d'un mélange HF/H₂O₂ le métal noble catalyse localement la dissolution du silicium. Cette solution d'attaque peut comprendre typiquement entre 4 ml : 1 ml : 8 ml (48% HF : 30% H₂O₂ : H₂O) et 4 ml : 1 ml : 40 ml (48% HF : 30% H₂O₂ : H₂O). La dissolution du silicium se produit préférentiellement sous le métal, celui-ci s'enfonçant alors progressivement dans le silicium. Cette réaction peut se poursuivre sur de grandes profondeurs (> 100 mµ) selon des modes de propagation essentiellement influencés par l'orientation du cristal de silicium, la disposition des surfaces, le dopage et la chimie du bain. Le procédé de type « MAC-Etch » présente l'avantage de ne pas nécessiter d'apport électrique dans le bain tout en autorisant la formation de pores de très grande profondeur (> 100 mµ) dans le silicium. Il est donc particulièrement adapté à l'utilisation, en tant que substrat, de wafers SOI généralement utilisés pour la fabrication des composants horlogers.

L'homme du métier connait les paramètres des procédés décrits ci-dessus à mettre en oeuvre pour que les pores formés dans le substrat à base de silicium présentent une géométrie et une taille appropriées.

Notamment, les pores peuvent présenter avantageusement un facteur d'aspect (rapport profondeur:diamètre) compris entre 1 et 200.

De préférence, les pores peuvent présenter une profondeur supérieure à 200 µm et plus préférentiellement supérieure à 300 µm.

Comme représenté sur la figure 2, la formation de pores 2 dans le substrat à base de silicium 1 sur une certaine profondeur entraine la formation, entre les pores 2, de piliers 3 à base de silicium sur la même profondeur. De préférence, en considérant les piliers à base de silicium comme ayant une section circulaire, les pores 2 sont formés de sorte que la surface projetée des piliers 3 à base de silicium est inférieure à 79% de la surface totale apparente afin de ne pas avoir de piliers à base de silicium qui se touchent.

Selon une première variante du procédé qui n'appartient pas à l'invention, en référence aux figures 1 à 3, le substrat à base de silicium poreux est utilisé pour créer une surface réelle de substrat très supérieure à la surface initiale, et en conséquence pour accroitre fortement le taux de dépôt apparent d'un matériau approprié.

Selon cette première variante, le procédé comprend, après l'étape b), une étape c) consistant à remplir entièrement les pores 2 formés dans le substrat à base de silicium 1 lors de l'étape b), d'un matériau choisi parmi le diamant, le carbone-diamant (DLC), l'oxyde de silicium, le nitrure de silicium, des céramiques, des polymères et leurs mélanges, afin de former dans les pores une couche dudit matériau d'une épaisseur au moins égale à la profondeur des pores.

Ainsi, le procédé permet de fabriquer, en surface du substrat à base de silicium, une couche épaisse d'un matériau approprié en un temps rapide, fortement réduit par rapport à un dépôt sur la surface plane d'un substrat similaire, mais non poreux.

Cette étape c) est effectuée directement après l'étape b), sans aucune étape intermédiaire, de sorte que le matériau déposé dans les pores est en contact direct avec les parois desdits pores.

De préférence, l'étape c) est réalisée par un procédé choisi parmi le groupe comprenant les procédés de dépôt de couche mince, tels que les procédés de dépôt chimique en phase vapeur (CVD), dépôt physique en phase vapeur (PVD), dépôt de couches minces atomiques (ALD), et l'oxydation thermique. Ces procédés sont connus de l'homme du métier et ne nécessitent pas d'informations détaillées ici. Il peut être précisé toutefois que lorsque l'étape c) est réalisée par un dépôt PVD, le facteur d'aspect des pores dans le substrat à base de silicium est de préférence inférieur ou égal à 4 : 1. Lorsque l'étape c) est réalisée par un dépôt CVD ou MOCVD (metal organic chemical vapor déposition), le facteur d'aspect des pores dans le substrat à base de silicium est de préférence inférieur ou égal à 50 :1. De plus, pour un dépôt par PVD, le taux de dépôt sera de préférence compris entre 0.1 et 5 nm/s. Pour un dépôt par CVD ou MOCVD, le taux de dépôt sera de préférence compris entre 0.01 et 10 nm/s. Pour un dépôt par ALD, le taux de dépôt sera par exemple de 0.01 nm/s. Par ailleurs, l'oxydation thermique est particulièrement avantageuse pour réduire la proportion de silicium dans un substrat en silicium, le silicium se faisant consommer par la croissance à raison d'environ 50% de l'épaisseur de la couche. Ainsi, l'homme du métier sait dimensionner les pores devant être formés dans un substrat de silicium afin de permettre un remplacement à 100% du silicium par du SiO₂ aboutissant ainsi à la formation d'une couche de SiO₂ très épaisse en un temps très court.

Avantageusement, le procédé comprend après l'étape c), une étape d) de formation d'une couche de surface 4 dudit matériau à la surface du substrat 1 et des pores 2 remplis du matériau. Plus particulièrement, cette couche de surface 4 peut être obtenue en prolongeant le dépôt du matériau selon l'étape c) de manière à non seulement remplir entièrement les pores 2 du matériau mais également à ensuite déposer ledit matériau sur les pores 2 remplis du matériau ainsi que sur les piliers 3 pour former une couche pleine 4 dudit matériau d'épaisseur h0, comme le montre la figure 3. On obtient ainsi une couche composite d'épaisseur h1 comprenant les piliers 3, les pores 2 remplis de matériau et la couche pleine 4. Ainsi, on peut avoir par exemple un rapport h0/h1 de l'ordre de 10%.

Ainsi, le procédé permet d'obtenir une pièce micromécanique horlogère comprenant une couche composite épaisse à base de silicium/matériau déposé, voire une couche épaisse de matériau déposé lorsque tout le silicium a été remplacé.

La formation de pores à partir de la surface du substrat lors de l'étape b) permet de créer une très forte corrugation afin de créer une surface réelle bien supérieure à la surface initiale, sans pores. L'homme du métier sait choisir la géométrie des pores ainsi que le temps de dépôt du matériau dans les pores, afin de fabriquer, en surface du silicium, une couche épaisse en un temps fortement réduit par rapport à un dépôt sur une surface plane. Plus particulièrement, l'homme du métier sait choisir la géométrie et la taille des pores de manière à :
- obtenir un remplissage complet des pores lors du dépôt du matériau,
- faciliter l'écoulement des gaz
- obtenir le rapport de volume souhaité entre la couche de matériau déposé et les pores de silicium. Il est possible par exemple de fabriquer du silicium poreux avec une porosité de plus de 90% si nécessaire.
Par exemple, pour certains procédés de dépôt tels que CVD et PVD, le taux de dépôt a tendance à être plus lent au fond des pores. Il est alors possible de prévoir des pores coniques (plus large en surface qu'en profondeur) afin de compenser ce phénomène lié à l'écoulement des gaz.

Ainsi, avec un apport de gaz suffisant dans les pores, le procédé selon l'invention permet d'obtenir une couche composite silicium/matériau déposé d'épaisseur h1 dans un temps de dépôt proche de celui nécessaire à l'obtention d'une couche pleine du matériau d'épaisseur h0 correspondant à la couche de surface 4.

Le procédé peut avantageusement être mis en oeuvre pour la fabrication de composants de l'échappement à base de silicium, tels que la roue d'échappement et l'ancre, en formant des couches épaisses de diamant par CVD.

Le procédé peut également être mis en oeuvre pour la fabrication de composants de l'échappement à base de silicium, en formant des couches épaisses de SiO2, quasiment massif si le procédé par oxydation thermique est utilisé pour le dépôt de SiO2.

Le procédé peut également être mis en oeuvre pour créer rapidement des couches locales très épaisses en profondeur dans le silicium, en le combinant à la structuration de zones en silicium poreux.

Selon une deuxième variante du procédé qui n'appartient pas à l'invention, les pores 2 sont formés selon l'étape b) sur une zone du substrat à base de silicium 1 correspondant à une surface décorative à réaliser. Le substrat à base de silicium poreux est alors utilisé pour créer sur la pièce micromécanique horlogère une surface de silicium poreux décorative de couleur très foncée, proche du noir. Les pores 2 sont agencés de manière à déboucher à la surface externe de la pièce micromécanique horlogère, afin de former une surface visible pour l'utilisateur.

L'homme du métier connait les paramètres des procédés décrits ci-dessus à mettre en oeuvre pour que les pores formés dans le substrat à base de silicium présentent une géométrie et une taille appropriées pour obtenir une zone de silicium poreux présentant un très haut pouvoir d'absorption de la lumière, dans le domaine du visible notamment, et anti-reflets.

Notamment, en assimilant les pores, dans le plan de la pièce, à des orifices de section circulaire, lesdits pores peuvent présenter de préférence un diamètre compris entre 10 nm et 1000 nm.

La zone de couleur obtenue est utilisée comme surface décorative sur la pièce micromécanique horlogère. Par surface décorative, on entend par exemple un dessin, un motif ou une inscription, telle que des chiffres, ou tout autre décor.

Ce procédé peut optionnellement comprendre, après l'étape b), une étape e) consistant à déposer au moins un revêtement sur la surface décorative en silicium poreux obtenue selon l'étape b).

Avantageusement, ce revêtement déposé à l'étape e) peut comprendre une couche de métallisation à base d'au moins l'un des éléments choisis parmi le groupe comprenant Cr, Ti, Ag, Pt, Cu, Ni, Pd, Rh. De préférence, la couche de métallisation est une fine couche, d'épaisseur inférieure à 50 nm.

Avantageusement, le revêtement déposé à l'étape e) peut comprendre également une couche transparente d'oxyde, tel que l'un des oxydes choisis parmi le groupe comprenant SiO₂, TiO₂ ZrO₂, HfO₂, Ta₂O₅ VO₂, ou leurs mélanges. La couche de métallisation ou la couche d'oxyde peuvent être utilisées seules, et être déposées par exemple directement sur le Si poreux, ou les deux couches peuvent être associées, la couche d'oxyde recouvrant alors la couche de métallisation. L'épaisseur de la couche d'oxyde est de préférence comprise entre 100 nm et 2000 nm.

Le revêtement d'une couche de métallisation et d'une couche transparente d'oxyde sur la surface décorative en silicium poreux permet d'obtenir une surface décorative de couleurs interférentielles.

Ce procédé peut avantageusement être mis en oeuvre pour la fabrication de pièces à base de silicium, telles que les cadrans.

Selon une autre variante du procédé qui n'appartient pas à l'invention, la formation de pores à partir de la surface du substrat à base de silicium permet de former une superstructure à base de silicium poreux présentant un certain degré de flexibilité capable d'accommoder différents régimes de pression en se déformant. De plus, ce type de structure présente des cavités qui permettent de contenir de manière durable une réserve importante de lubrifiant.

De plus, dans le cas où des brosses polymères sont déposées sur la superstructure à base de silicium poreux, le revêtement obtenu est capable de se gorger de lubrifiant et de le restituer lorsque ces brosses polymères sont comprimées. Ce revêtement favorise également la pénétration du lubrifiant dans les cavités de la superstructure à base de silicium poreux

Selon cette variante, les pores 2 sont formés à partir de la surface dudit substrat à base de silicium 1 sur une zone du substrat à base de silicium 1 correspondant à une zone à lubrifier par un agent tribologique. Les pores peuvent être formés de préférence à la surface perpendiculaire au plan du substrat, c'est-à-dire sur les flancs de la pièce micromécanique qui sont en frottement, mais également à la surface parallèle au plan du substrat.

Selon cette variante, il est prévu, après l'étape b), une étape f) consistant à déposer dans les pores 2, entre les piliers 3, un agent tribologique. L'agent tribologique est un lubrifiant, et peut être liquide, par exemple sous la forme d'une solution aqueuse, ou sec. D'une manière préférée, ledit agent tribologique est un polymère perfluorocarboné, tel que le polytétrafluoroéthylène (PTFE), ou tout autre agent tribologique ou lubrifiant approprié.

Selon un premier mode de réalisation, l'agent tribologique est déposé selon l'étape f) directement dans les pores 2 du substrat à base de silicium. Cette étape f) peut être réalisée par un procédé de dépôt de couche mince, tel que CVD, iCVD, PECVD. Un traitement thermique approprié peut être appliqué pour polymériser l'agent tribologique, à des températures de l'ordre de 100°C à 300°C. Ainsi, des quantités importantes d'agent tribologique peuvent être emmagasinées à proximité de la surface du substrat à base de silicium, tout en conservant une dureté de surface apparente relativement élevée du fait du silicium.

D'une manière particulièrement avantageuse, les paramètres du procédé de formation des pores 2 dans le substrat à base de silicium 1 selon l'étape b) sont choisis pour que les pores 2 présentent une géométrie et une taille appropriées de sorte que les piliers 3, formés entre les pores 2, constituent des filaments 3' à base de silicium. Ces filaments 3' présentent un facteur d'aspect (rapport profondeur:diamètre) compris entre 5 et 100. Les filaments forment une superstructure flexible et sont ensuite imprégnés d'un agent tribologique choisi pour faciliter le mouillage des pores, conformément à l'étape b) du procédé.

Un substrat comprenant des filaments à base de silicium peut être utilisé selon deux autres modes de réalisation de cette variante du procédé.

Plus particulièrement en référence aux figures 4 à 6, selon un deuxième mode de réalisation, il est prévu conformément à l'étape b) de réaliser dans un substrat à base de silicium 1 des pores 2 de manière à former entre les pores 2 des piliers 3 sous la forme de filaments 3', comme le montre la figure 4. Il est alors prévu entre les étapes b) et f), une étape g) de dépôt d'au moins un agent de mouillage 6 de l'agent tribologique sur les parois des filaments 3' à base de silicium. L'agent de mouillage 6 est choisi pour faciliter le mouillage et la pénétration de l'agent tribologique. Il est appliqué pour former une couche très mince (quelques nanomètres) afin de fonctionnaliser les parois des filaments 3' à base de silicium. Puis les filaments 3' sont imprégnés par un agent tribologique 5, selon l'étape f), l'agent tribologique 5 étant choisi pour faciliter le mouillage des pores 2.

En référence aux figures 7 à 9, selon un troisième mode de réalisation, il est prévu conformément à l'étape b) de réaliser dans un substrat à base de silicium 1 des pores 2 de manière à former entre les pores 2 des piliers 3 sous la forme de filaments 3', comme le montre la figure 7. Il est alors prévu entre les étapes b) et f), une étape h) de dépôt d'au moins une brosse polymère 8 sur les parois des filaments 3' à base de silicium. Une telle brosse polymère 8 est décrite par exemple dans les publications WO 2012/152512 et WO 2014/009059. Les brosses polymères présentent des filaments de longueur inférieure à celle des filaments à base de silicium de sorte que les filaments de polymère sont protégés par les filaments à base de silicium plus résistants mécaniquement. Puis les filaments 3' à base de silicium et les brosses polymères 8 sont imprégnés par un agent tribologique 5, selon l'étape f), l'agent tribologique 5 étant choisi pour faciliter le mouillage.

Cette variante de procédé permet de fabriquer des filaments directement dans la matière du substrat à base de silicium avec des géométries et des propriétés de flexion mécanique contrôlées permettant en cas d'utilisation de brosses polymères, de maintenir le comportement de supra-lubrification sur une large plage de régime de frottement tout en augmentant la fiabilité. Ainsi, le procédé selon l'invention permet de pallier au manque de résistance mécanique des brosses polymères habituellement utilisées en supra-lubrification. La structure formée de filaments à base de silicium constitue un réservoir de lubrifiant capable de restituer la quantité suffisante de lubrifiant dans le contact en fonction des sollicitations.

La géométrie des pores et des filaments à base de silicium peut être optimisée en fonction des régimes de frottement et objectifs tribologiques visés. La structuration du substrat à base de silicium peut aller de filaments à base de silicium à des pores ouverts et désordonnées formant une couche spongieuse

Selon le procédé de l'invention, les pores 2 sont formés sur le substrat à base de silicium 1 pour constituer au moins une zone superhydrophobe à effet épilame par rapport à au moins une zone du substrat à base de silicium ne comprenant pas de pore et sur laquelle est appliqué un agent tribologique. Cet effet peut être renforcé par une fonctionnalisation localisée.

## Revendications

1. Procédé de fabrication d'une pièce micromécanique horlogère à partir d'un substrat à base de silicium (1), comprenant dans l'ordre, les étapes de :
a) se munir d'un substrat à base de silicium (1),
b) former des pores (2) à la surface d'au moins une partie d'une surface dudit substrat à base de silicium (1) d'une profondeur d'au moins 10 µm, de préférence d'au moins 50 µm, et plus préférentiellement d'au moins 100 µm, lesdits pores étant agencés pour déboucher à la surface externe de la pièce micromécanique horlogère,
dans lequel les pores (2) sont formés sur le substrat à base de silicium (1) pour constituer au moins une zone superhydrophobe à effet épilame par rapport à au moins une zone du substrat à base de silicium ne comprenant pas de pore et sur laquelle est appliqué un agent tribologique.

2. Procédé selon l'une des revendications précédentes, dans lequel les pores présentent un facteur d'aspect (rapport profondeur:diamètre) compris entre 1 et 200.

3. Procédé selon l'une des revendications précédentes, dans lequel les pores (2) présentent une profondeur supérieure à 200 µm et plus préférentiellement supérieure à 300 µm.

4. Procédé selon l'une des revendications précédentes, dans lequel le substrat à base de silicium (1) est issu d'un wafer de silicium ou d'un wafer SOI (Silicon-on-Insulator).

5. Pièce micromécanique horlogère comprenant un substrat à base de silicium (1) qui présente, à la surface d'au moins une partie d'une surface dudit substrat à base de silicium (1), des pores (2) d'une profondeur d'au moins 10 µm, de préférence d'au moins 50 µm, et plus préférentiellement d'au moins 100 µm, lesdits pores étant agencés pour déboucher à la surface externe de la pièce micromécanique horlogère, **caractérisée en ce que** les pores (2) sont agencés sur le substrat à base de silicium (1) pour constituer au moins une zone superhydrophobe à effet épilame par rapport à au moins une zone du substrat à base de silicium ne comprenant pas de pore et sur laquelle est appliqué un agent tribologique.

## Patentansprüche

1. Verfahren zum Herstellen eines mikromechanischen Uhrenteils anhand eines Substrats (1) auf Siliciumbasis, das in dieser Reihenfolge die folgenden Schritte umfasst:
a) Bereitstellen eines Substrats (1) auf Siliciumbasis,
b) Bilden von Poren (2) in der Oberfläche zumindest eines Teils einer Oberfläche des Substrats (1) auf Siliciumbasis mit einer Tiefe von mindestens 10 µm, vorzugsweise mindestens 50 µm und besonders bevorzugt mindestens 100 µm, wobei die Poren dafür ausgelegt sind, in die äußere Oberfläche des mikromechanischen Uhrenteils zu münden,
wobei die Poren (2) in dem Substrat (1) auf Siliciumbasis gebildet sind, um mindestens einen superhydrophoben Bereich mit Epilamisierungswirkung zu bilden in Bezug auf mindestens einen Bereich des Substrats auf Siliciumbasis, der keine Pore aufweist und auf den ein tribologisches Mittel aufgebracht ist.

2. Verfahren nach einem der vorhergehenden Ansprüche, wobei die Poren einen Formfaktor (Verhältnis von Tiefe zu Durchmesser) im Bereich von 1 bis 200 aufweisen.

3. Verfahren nach einem der vorhergehenden Ansprüche, wobei die Poren (2) eine Tiefe von mehr als 200 µm und besonders bevorzugt von mehr als 300 µm aufweisen.

4. Verfahren nach einem der vorhergehenden Ansprüche, wobei das Substrat (1) auf Siliciumbasis von einem Silicium-Wafer oder von einem SOI (Silicon-on-Insulator)-Wafer stammt.

5. Mikromechanisches Uhrenteil, umfassend ein Substrat (1) auf Siliciumbasis, das auf der Oberfläche zumindest eines Teils einer Oberfläche des Substrats (1) auf Siliciumbasis Poren (2) mit einer Tiefe von mindestens 10 µm, vorzugsweise mindestens 50 µm und besonders bevorzugt mindestens 100 µm aufweist, wobei die Poren dafür ausgelegt sind, in die äußere Oberfläche des mikromechanischen Uhrenteils zu münden, **dadurch gekennzeichnet, dass** die Poren (2) auf dem Substrat (1) auf Siliciumbasis angeordnet sind, um mindestens einen superhydrophoben Bereich mit Epilamisierungswirkung zu bilden in Bezug auf mindestens einen Bereich des Substrats auf Siliciumbasis, der keine Pore aufweist und auf den ein tribologisches Mittel aufgebracht ist.

## Claims

1. Method for manufacturing a micromechanical timepiece part starting from a silicon-based substrate (1), comprising, in order, the steps of:
a) providing a silicon-based substrate (1),
b) forming pores (2) on the surface of at least one part of a surface of said silicon-based substrate (1) of a depth of at least 10 µm, preferably of at least 50 µm, and more preferably of at least 100 µm, said pores being designed in order to open out at the external surface of the micromechanical timepiece part,
wherein the pores (2) are formed on the silicon-based substrate (1) in order to form at least one super-hydrophobic zone with an epilame effect relative to at least one zone of the silicon-based substrate not comprising pores and on which a tribological agent is applied.

2. Method according to one of the preceding claims, wherein the pores have an aspect factor (depth : diameter ratio) between 1 and 200.

3. Method according to one of the preceding claims, wherein the pores (2) have a depth greater than 200 µm and more preferably greater than 300 µm.

4. Method according to one of the preceding claims, wherein the silicon-based substrate (1) is a silicon wafer or an SOI wafer (Silicon-on-Insulator).

5. Micromechanical timepiece part comprising a silicon-based substrate (1) which has, on the surface of at least one part of a surface of said silicon-based substrate (1), pores (2) of a depth of at least 10 µm, preferably of at least 50 µm, and more preferably of at least 100 µm, said pores being designed in order to open out at the external surface of the micromechanical timepiece part, **characterised in that** the pores (2) are designed on the silicon-based substrate (1) in order to form at least one super-hydrophobic zone with an epilame effect relative to at least one zone of the silicon-based substrate not comprising pores and on which a tribological agent is applied.
